# EUROPEAN PATENT APPLICATION

(11) **EP 1 998 372 A1**
(43) Date of publication of application: **03.12.2008**
(21) Application number: 08009570.6
(22) Date of filing: 26.05.2008
(51) Int. Cl.: H01L 27/12

(54) **SOI semiconductor device**

(30) Priority: 30.05.2007 JP 2007143439; 30.04.2008 JP 2008118504
(71) Applicant: NEC Electronics Corporation, Kawasaki, Kanagawa 211-8668 (JP)
(72) Inventor: Ito, Masayuki, Kawasaki Kanagawa 211-8668 (JP); Fujiwara, Akira, Kawasaki Kanagawa 211-8668 (JP); Inoue, Katsuhiro, Kumamoto-shi Kumamoto (JP)
(74) Representative: Glawe, Delfs, Moll

(57) **Abstract**

Provided is a semiconductor device that is capable of suppressing occurrence of a crystal defect in an elongated circuit region formed in an SOI substrate. Low-voltage transistor regions are separated, by multiple inner isolation layers, into multiple sub-regions. For this reason, the length of the longitudinal direction of the sub-regions is reduced, even though the low-voltage transistor regions are extremely elongated, for example. This configuration can suppress occurrence of a crystal defect in the low-voltage transistor regions in the longitudinal direction thereof, although such defect may occur due to the difference in thermal expansion or thermal contraction between a semiconductor layer in the low-voltage transistor regions, and the element isolation layers.

## Description

### BACKGROUND OF THE INVENTION

### 1. Field of the Invention

The present invention relates to a semiconductor device in which a semiconductor circuit is formed in an SOI (Semiconductor On Insulator) substrate. More particularly,the present invention relates to a semiconductor device in which multiple semiconductor circuits are formed in an array in circuit element regions of an SOI substrate.

### 2. Description of the Related Art

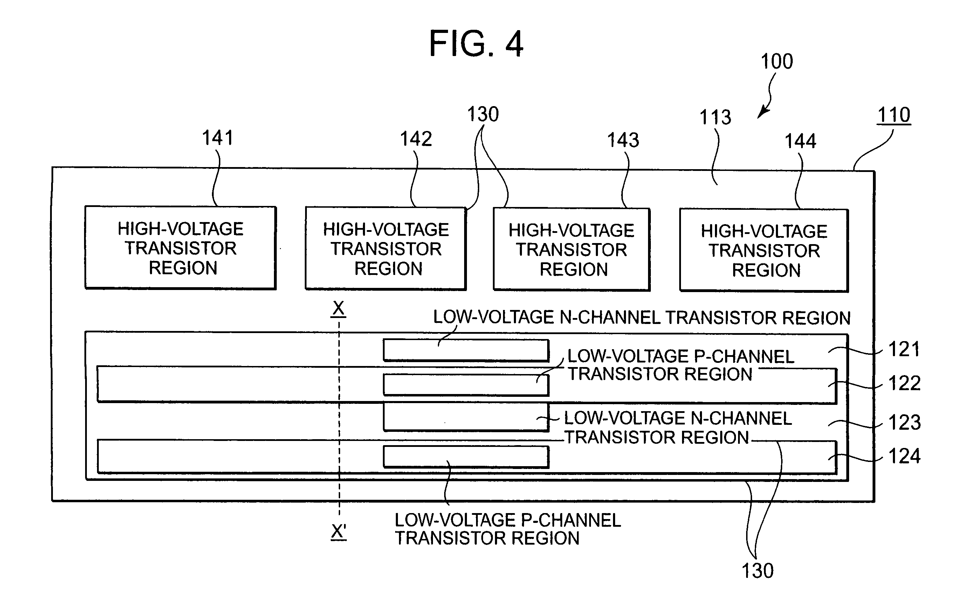

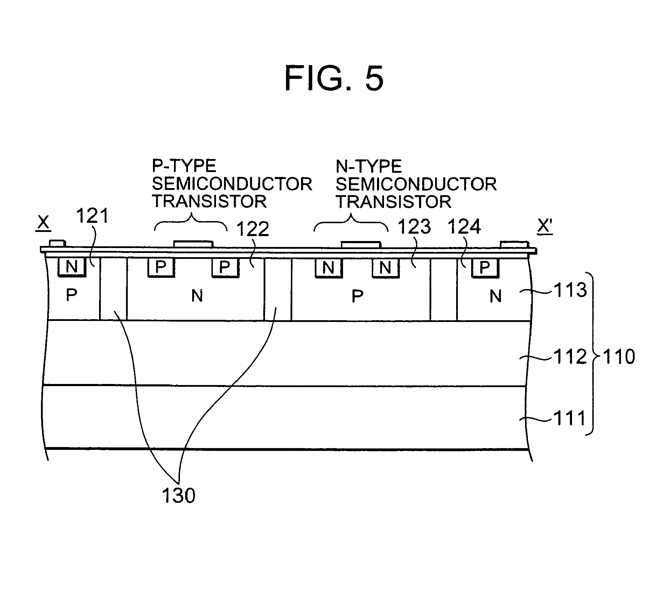

A conventional example of a semiconductor device in which semiconductor circuits are formed in an SOI substrate will be described hereinbelow with reference to FIG. 4 and FIG. 5, which is a schematic longitudinal side section view taken along the line X-X' of FIG. 4. A semiconductor device 100 illustrated as an example here includes an SOI substrate 110 in which a semiconductor layer 113 is laminated on a semiconductor substrate 111 with an intermediate insulating layer 112 interposed therebetween.

In the semiconductor layer 113, multiple low-voltage transistor regions 121 to 124 are formed as circuit element regions. In the low-voltage transistor regions 121 to 124, multiple semiconductor circuits each having the same function (not illustrated) are formed in an array.

Accordingly, the low-voltage transistor regions 121 to 124 are formed in an elongated shape extending in the left and right direction. In addition, the low-voltage transistor regions 121 to 124 are lined up to be adjacent to one another in parallel to the longitudinal direction thereof.

The semiconductor layer 113 in the low-voltage transistor regions 121 to 124 which are arranged as described above is formed into n-type semiconductor layers and p-type semiconductor layers, which are alternately arranged. Accordingly, the low-voltage transistor regions represented by odd reference numbers 121 and 123 are each formed of a p-type semiconductor in which a part of a semiconductor circuit is formed of n-type transistors. The low-voltage transistor regions represented by even reference numbers 122 and 124 are each formed of an n-type semiconductor in which a part of a semiconductor circuit is formed of p-type transistors. In other words, these multiple n-type semiconductor transistors and p-type semiconductor transistors constitute a semiconductor circuit to perform a function.

The semiconductor layer 113 in the low-voltage transistor regions 121 to 124 arranged as described above is formed into n-type semiconductor layers and p-type semiconductor layers, which are alternately arranged. Accordingly, an element isolation layer 130 is formed from the upper surface of the semiconductor layer 113 to the upper surface of the intermediate insulating layer 112. The element isolation layer 130 is shaped to separate the low-voltage transistor regions 121 to 124 from the regions other than the low-voltage transistor regions 121 to 124 (hereinafter referred to as "peripheral regions").

The element isolation layer 130 is formed of an insulating film, for example. Specifically, the element isolation layer 130 may be formed of a layer film that is made of NSG (Nondope Silicate Glass), SOG (Spin on Glass), polysilicon or the like buried in the semiconductor layer 113. Such element isolation layer 130 is capable of insulating the multiple low-voltage transistor regions 121 to 124 from one another.

Note that, rectangular high-voltage transistor regions 141 to 144 are formed in the semiconductor device 100 in addition to the above-mentioned low-voltage transistor regions 121 to 124. The rectangular high-voltage transistor regions 141 to 144 are also separated, by the element isolation layer 130, from the peripheral regions.

In the semiconductor device 100 as described above, a low-voltage section of a driver circuit is formed of the semiconductor circuits in the low-voltage transistor regions 121 to 124, for example. The driver circuit is used for image data to be outputted to be displayed on a display device.

Such a driver circuit performs matrix drive of display pixels that are arranged on the display device. Accordingly, in the low-voltage transistor regions 121 to 124, multiple semiconductor circuits having the same function and driving the respective display pixels are formed in an array, for example.

The multiple semiconductor circuits are formed of transistor elements or capacitive elements (not illustrated). The multiple semiconductor circuits are formed to have the same structure so as to perform the same function. For this reason, semiconductor transistors constituting the multiple semiconductor circuits are formed in the same pattern (not illustrated).

In addition to a mask layout having the same pattern as described above, however, there are a mask layout having adjacent patterns disposed to be mirror-inverted to each other, and a mask layout having the combination of these layouts.

Various propositions have been made for a semiconductor device in which semiconductor circuits are formed in an SOI substrate as described above (For example, see Japanese Patent Application Publication Nos. 2001-015589, Hei 08-204130, and Hei 11-274501).

In the semiconductor device 100 as described above, semiconductor circuits each having the same function are arranged in the elongated low-voltage transistor regions 121 to 124, in order to function as a driver circuit for image data. The low-voltage transistor regions 121 and 123 in which n-type semiconductor transistors are formed, and the low-voltage transistor regions 122 and 124 in which p-type semiconductor transistors are formed, are insulated from one another by the element isolation layer 130.

However, the element isolation layer 130 formed of an insulating film or the like is different from the low-voltage transistor regions 121 to 124 and the semiconductor layer 113 in the peripheral regions, which are formed of semiconductors, in terms of thermal expansion rate or thermal contraction rate.

Additionally, each of the low-voltage transistor regions 121 to 124 is formed in an extremely elongated shape. Accordingly, the difference in thermal expansion or thermal contraction in the longitudinal direction is considerable between the semiconductor layer 113 of the low-voltage transistor regions 121 to 124 and the element isolation layer 130.

For this reason, in the manufacturing process of the semiconductor device 100, the elongated low-voltage transistor regions 121 to 124 may have a crystal defect in the longitudinal direction thereof in the manufacturing process of the semiconductor device 100, and such crystal defect may cause a leak current at the p-n junction.

### SUMMARY OF THE INVENTION

A semiconductor device according to the present invention includes: an SOI substrate in which a semiconductor layer is laminated on a semiconductor substrate with an intermediate insulating layer interposed therebetween; a circuit element region in which multiple semiconductor circuits each having the same function are formed in an array in the semiconductor layer; an insulative element isolation layer having a shape that separates the circuit element region from a peripheral region, and being formed from the upper surface of the semiconductor layer to the upper surface of the intermediate insulating layer; and multiple insulative inner isolation layers each having a shape that separates the circuit element region into multiple sub-regions, and being formed from the upper surface of the semiconductor layer to the upper surface of the intermediate insulating layer.

With this configuration, in the semiconductor device according to the present invention, the circuit element region is separated, by the multiple inner isolation layers, into the multiple sub-regions. Accordingly, the length of the longitudinal direction of the sub-regions is reduced, even though the low-voltage transistor regions are extremely elongated, for example. This configuration can suppress occurrence of a crystal defect in the circuit element region in the longitudinal direction thereof, although such defect may occur due to the difference in thermal expansion or thermal contraction between a semiconductor layer in the circuit element region, and the inner isolation layer.

Note that various components of the present invention are not necessarily discrete. Instead, the present invention encompasses the following cases: multiple components are formed into a single member; a component is formed of multiple members; one component is a part of another component; a part of one component overlapping a part of another component; and the like.

In the semiconductor device of the present invention, since a circuit element region is separated into multiple sub-regions by the multiple inner isolation layers, the length of the sub-regions is reduced in the longitudinal direction, even though the circuit element region is extremely elongated, for example. This configuration can suppress occurrence of a crystal defect in the circuit element region in the longitudinal direction thereof, although such defect may occur due to the difference in thermal expansion or thermal contraction between the semiconductor layer in the transistor element region, and the element isolation layer. Accordingly, occurrence of a p-n junction leak current attributable to the crystal defect can be suppressed in the circuit element region.

### BRIEF DESCRIPTION OF THE DRAWINGS

FIG. 1 is a schematic plan view showing a planar shape of a semiconductor device according to an embodiment of the present invention.
FIG. 2 is a schematic plan view showing the planar shape of a main portion of the semiconductor device according to the embodiment of the present invention.
FIG. 3 is a schematic plan view showing a planar shape of a semiconductor device according to a modified example of the present invention.
FIG. 4 is a schematic plan view showing a planar shape of a conventional semiconductor device.
FIG. 5 is a schematic longitudinal side section view showing an inner structure of a main portion of the conventional semiconductor device.

### DESCRIPTION OF THE PREFERRED EMBODIMENT

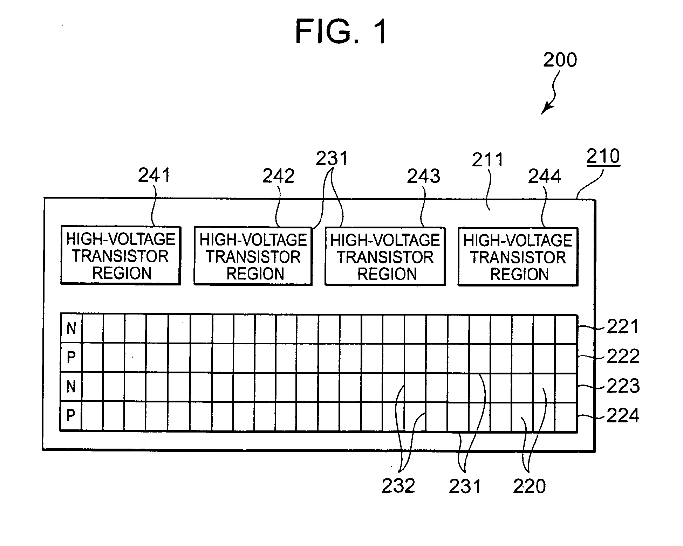

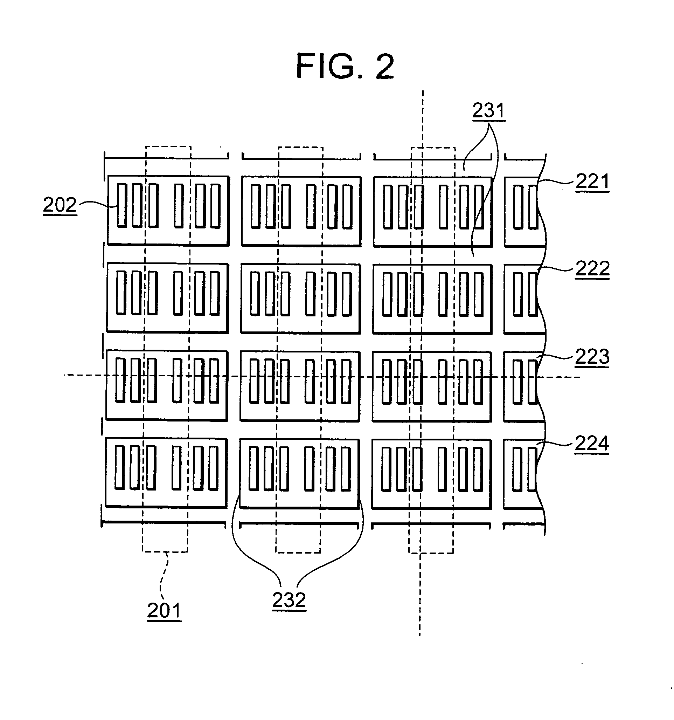

An embodiment of the present invention will be described hereinafter with reference to FIG. 1 and FIG. 2. However, the same parts as those of the above-described conventional example will be denoted by the same name, and a detailed description thereof will be omitted.

As shown in FIG. 1, a semiconductor device 200 of this embodiment includes: an SOI substrate 210; low-voltage transistor regions 221 to 224; element isolation layers 231; and multiple inner isolation layers 232. The SOI substrate 210 is a semiconductor substrate on which a semiconductor layer 211 is laminated with an intermediate insulating layer interposed therebetween. The low-voltage transistor regions 221 to 224 are circuit element regions in which multiple semiconductor circuits 201 having the same function are formed in an array in the semiconductor layer 211. Each of the element isolation layers 231 is insulative and has a shape to separate the low-voltage transistor regions 221 to 224 from peripheral regions, and is formed from the upper surface of the semiconductor layer 211 to the upper surface of the intermediate insulating layer. Each of the multiple inner isolation layers 232 is insulative and has a shape to separate the low-voltage transistor regions 221 to 224 into multiple sub-regions 220, and is formed from the upper surface of the semiconductor layer 211 to the upper surface of the intermediate insulating layer.

To be more specific, each of the low-voltage transistor regions 221 to 224 is formed in an extremely elongated shape in which the multiple semiconductor circuits 201 are arranged in an array, whereas each of the multiple inner isolation layers 232 is formed at a position that divides each of the elongated low-voltage transistor regions 221 to 224 into multiple pieces in the longitudinal direction.

The multiple semiconductor circuits 201 formed of low-voltage transistors is arranged in an array in the low-voltage transistor regions 221 to 224, whereas the multiple inner isolation layers 232 are formed at positions that partition the multiple semiconductor circuits 201 from one another.

Note that, the element isolation layers 231 and the inner isolation layers 232 are integrally formed an insulating film obtained by oxidizing the semiconductor layer 211. However, as described above, each of the element isolation layers 231 is formed to electrically insulate the low-voltage transistor regions 221 to 224 from one another and from the peripheral regions.

Moreover, the inner isolation layers 232 are formed at positions that isolate the multiple semiconductor circuits 201 from one another, but are not formed with an aim to electrically insulate the multiple semi conductor circuits 201 from one another. Instead, the inner isolation layers 232 are formed with an aim to reduce mechanical stress (such as thermal expansion or thermal contraction) by separating the extremely elongated low-voltage transistor regions 221 to 224 into multiple pieces in the longitudinal direction. For this reason, it is a matter of course that the effects of the present invention can also be obtained in the following application. Specifically, each of power wires and the like is disposed in the longitudinal direction of the low-voltage transistor regions 221 to 224 so as to be commonly connected to the multiple semiconductor circuits 201, or in other words, so as not to electrically isolate the multiple semiconductor circuits 201.

In each of the sub-regions 220, multiple n-type semiconductor transistors and multiple p-type semiconductor transistors are formed as constituents of the semiconductor circuits 201. As shown in FIG. 2, since the multiple semiconductor circuits 201 are arrayed in the semiconductor layer 211, the multiple semiconductor transistors 202 are also formed in the same pattern from one sub-region 220 to another.

The semiconductor transistors 202 each are formed in an elongated shape perpendicular to the longitudinal direction of the low-voltage transistor regions 221 to 224, and are arranged at any given interval in the longitudinal direction of the low-voltage transistor regions 221 to 224.

As shown in FIG. 1, in the semiconductor device 200 of this embodiment, the multiple elongated low-voltage transistor regions 221 to 224 are lined up in the direction perpendicular to the longitudinal direction thereof. Additionally, the semiconductor layer 211 in the multiple low-voltage transistor regions 221 to 224 arranged in this way is formed into n-type semiconductor layers and p-type semiconductor layers, which are alternately arranged.

Moreover, in the semiconductor device 200 of this embodiment, a driver circuit for creating image data to be outputted to be displayed on a display device is formed of the multiple semiconductor circuits 201 in the low-voltage transistor regions 221 to 224.

Note that, also in the semiconductor device 200 of this embodiment, rectangular high-voltage transistor regions 241 to 244, for example, are formed in addition to the above-mentioned low-voltage transistor regions 221 to 224.

In the respective high-voltage transistor regions 241 to 244, high-voltage functional circuits each having the same function and each made of multiple high-voltage transistors are formed. The high-voltage transistor regions 241 to 244 are also separated, by the element isolation layers 231, from the peripheral regions.

Note that,these multiple high-voltage transistors of each high-voltage functional circuit are isolated from one another by the element isolation layers 231 so as to prevent latch-up or a high-voltage leak current (not illustrated).

With the above-mentioned configuration, in the semiconductor device 200 of this embodiment, the multiple semiconductor circuits 201 each having the same function are arrayed in the elongated high-voltage transistor regions 241 to 244 so as to function as a driver circuit for image data. The low-voltage transistor regions 221 to 224 are insulated from one another by the element isolation layers 231.

Also in the semiconductor device 200 of this embodiment, each of the above-mentioned low-voltage transistor regions 221 to 224 is formed in an extremely elongated shape. Moreover, the element isolation layers 231 formed of insulating films are different from the low-voltage transistor regions 221 to 224 and the semiconductor layer 211 acting as the peripheral regions, which are formed of semiconductor in terms of thermal expansion rate or thermal contraction rate.

In the semiconductor device 200 of this embodiment, however, the low-voltage transistor regions 221 to 224 are separated, by the multiple inner isolation layers 232, into the multiple sub-regions 220. As a result, even though each of the low-voltage transistor regions 221 to 224 is formed in an extremely elongated shape as described above, the length of the longitudinal direction of the sub-regions 220 is reduced.

This configuration can suppress occurrence of a crystal defect in the low-voltage transistor regions 221 to 224 in the longitudinal direction thereof, although such defect may occur due to the difference in thermal expansion or thermal contraction between the sub-regions 220 of the low-voltage transistor regions 221 to 224, and the element isolation layers 231.

Accordingly, occurrence of a p-n junction leak current due to the crystal defect can be suppressed in the low-voltage transistor regions 221 to 224. Thus, the performance or yield of the semiconductor device 200 can be improved.

In particular, the inner isolation layers 232 are formed at positions that separate the multiple semiconductor circuits 201 from one another. For this reason, the function of the semiconductor circuits 201 is not inhibited by the inner isolation layers 232. In addition, since each of the sub-regions 220, which are large in number, has the same inner structure, it is possible to provide the semiconductor device 200 having a structure that achieves high productivity.

Furthermore, the inner isolation layers 232 and the element isolation layers 231 are integrally formed of an insulating film obtained by oxidizing the semiconductor layer 211. For this reason, the inner isolation layers 232 can be formed at the same time as the element isolation layers 231, which are conventionally essential. In this way, the semiconductor device 200 having high productivity can be provided, because a dedicated manufacturing process to form the inner isolation layers 232 is not required.

Note that, the present inventors actually prototyped the semiconductor device 100 having a structure of the conventional example and the semiconductor device 200 having a structure of this embodiment, and conducted an experiment to determine whether or not a crystal defect occurs due to heat treatment in the low-voltage transistor regions 121 to 124 and the low-voltage transistor regions 221 to 224.

As a result of the experiment, it was found that the elongated low-voltage transistor regions 121 to 124 had a crystal defect in the longitudinal direction thereof, in the semiconductor device 100 having a structure of the conventional example. In contrast, it was found that the elongated low-voltage transistor regions 221 to 224 did not have a crystal defect in the longitudinal direction thereof, in the semiconductor device 200 having a structure of this embodiment.

It should be noted that the present invention is not limited to this embodiment and allows various modifications to be made without departing from the scope of the present invention. For example, in the above embodiment, the description has been given of the exemplar case in which high productivity of the semiconductor device 200 has been achieved because the element isolation layers 231 and the inner isolation layers 232 are integrally formed of an insulating film obtained by oxidizing the semiconductor layer 211.

However, what is required for the above-mentioned inner isolation layers 232 is only to separate the elongated low-voltage transistor regions 221 to 224 into pieces in the longitudinal direction. For this reason, the inner isolation layers 232 and the element isolation layers 231 may be formed of a layer in which polysilicon is buried in NSG, SOG, or sidewalls covered with an insulating film.

Moreover, in the above embodiment, as shown in FIG. 2, the description has been given of the exemplar case in which each of the multiple semiconductors 202, which are constituents of the semiconductor circuits 201, in the sub-regions 220 is formed in an elongated shape perpendicular to that of the low-voltage transistor regions 221 to 224, and in which is arranged in the longitudinal direction of the low-voltage transistor regions 221 to 224.

However, each of the multiple semiconductors, which are constituents of the semiconductor circuits, in the sub-regions may be formed in an elongated shape that is parallel to the longitudinal direction of the low-voltage transistor regions, or may be arranged in such a direction as perpendicular to the longitudinal direction of the elongated low-voltage transistor regions (both are not illustrated).

In addition, in the above embodiment, the description has been given of the exemplar case in which a low-voltage section of a driver circuit for image data to be outputted to be displayed on a display device is formed of the semiconductor circuits 201 on the low-voltage transistor regions 221 to 224 acting as circuit element regions.

However, a low-voltage section of a driver circuit for a line head of a line printer, or a low-voltage section of a driver circuit for a scanning head of a line scan may be formed of the semiconductor circuits 201 in the low-voltage transistor regions 221 to 224, for example.

Furthermore, in the above embodiment, the description has been given of the exemplar case in which the multiple semiconductor circuits 201 are arranged in a line in the low-voltage transistor regions 221 to 224. However, the multiple semiconductor circuits 201 may be arranged in multiple lines in the low-voltage transistor regions 221 to 224 (not illustrated).

Additionally, in the above embodiment, the description has been given of the exemplar case in which the inner isolation layers 232 are formed at positions that separate the multiple semiconductor circuits 201 from one another. However, the inner isolation layers may be formed at positions that separate the multiple semiconductor circuits into sets of a predetermined number of the semiconductor circuits, or may be formed at positions that divide the semiconductor circuits fromone another (both are not illustrated).

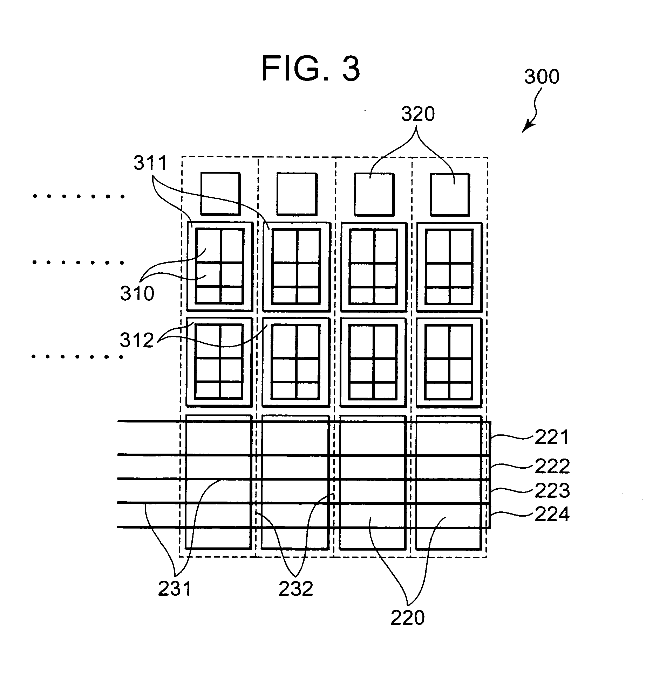

To be more specific, a semiconductor device 300 illustrated by an example in FIG. 3 includes multiple high-voltage functional circuits 311 each having the same function and multiple high-voltage functional circuits 312 each having the same function, and each of the high-voltage functional circuits 311 and 312 is formed of multiple high-voltage transistors 310. Each of the multiple high-voltage functional circuits 311 is formed of p-type high-voltage transistors 310, whereas each of the multiple high-voltage functional circuits 312 is formed of n-type high-voltage transistors 310.

As described above, the multiple high-voltage transistors 310 of the high-voltage functional circuits 311 and 312 are isolated from each other by the element isolation layers 231 so as to prevent latch-up or a high-voltage leak current. The multiple high-voltage functional circuits 311 and 312 arranged in lines parallel to the longitudinal direction of the elongated low-voltage transistor regions 221 to 224.

In other words, the multiple high-voltage functional circuits 311 and 312 are separated into blocks according to the units of function for a driver circuit, and the separatedmultiple high-voltage functional circuits 311 and 312 are arranged in the longitudinal direction of the elongated low-voltage transistor regions 221 to 224. Additionally, in the low-voltage transistor regions 221 to 224, the inner isolation layers 232 are formed on the extended lines of the respective positions in which the multiple high-voltage functional circuits 311 and 312 are separated into blocks.

Semiconductor circuits (not illustrated) that are made of the low-voltage transistors in the sub-regions 220 which are separated by the inner isolation layers 232 are formed in units of function for a driver circuit corresponding to the above-mentioned multiple high-voltage functional circuits 311 and 312.

With this configuration, the multiple high-voltage functional circuits 311 and 312 and the semiconductor circuits in the multiple sub-regions 220 of the low-voltage transistor regions 221 to 224 can be efficiently wired to connection pads 320 or the like, according to the units of function.

Moreover, the inner isolation layers 232 of the low-voltage transistor regions 221 to 224 are formed on the extended lines of the respective positions in which the multiple high-voltage functional circuits 311 and 312 are separated into blocks. With this configuration, the low-voltage transistor regions 221 to 224 are not extended in the longitudinal direction for the purpose of forming the inner isolation layers 232. As a result, this configuration eliminates the need to increase the circuit size of the semiconductor device 300.

Note that, it is a matter of course that the above-mentioned embodiment and multiple modified examples can be combined as long as the contents thereof do not contradict each other. In addition, in the embodiment and modified examples, although configuration or the like of each section has been described in detail, such configuration or the like can be variously modified within a range that satisfies the present invention.

## Claims

1. A semiconductor device comprising:
an SOI substrate in which a semiconductor layer is laminated on a semiconductor substrate with an intermediate insulating layer interposed therebetween;
a circuit element region in which a plurality of semiconductor circuits each having the same function are formed in an array in the semiconductor layer;
an insulative element isolation layer having a shape that separates the circuit element region from a peripheral region, and being formed from the upper surface of the semiconductor layer to the upper surface of the intermediate insulating layer; and
a plurality of insulative inner isolation layers each having a shape that separates the circuit element region into a plurality of sub-regions, and being formed from the upper surface of the semiconductor layer to the upper surface of the intermediate insulating layer.

2. The semiconductor device according to claim 1, wherein
the circuit element region in which the plurality of semiconductor circuits are arranged in the array is formed in an elongated shape, and
the inner isolation layers are formed at positions that divide the circuit element region into a plurality of pieces in a longitudinal direction thereof.

3. The semiconductor device according to claim 2, wherein
the plurality of semiconductor circuits are arranged in at least one line in the circuit element region, and
the inner isolation layers are formed at positions that separate the plurality of semiconductor circuits from one another.

4. The semiconductor device according to claim 2, wherein
the plurality of semiconductor circuits are arranged in at least one line in the circuit element region, and
the inner isolation layers are formed at positions that separate the plurality of semiconductor circuits into sets of a predetermined number of the semiconductor circuits.

5. The semiconductor device according to claim 4, further comprising
a plurality of high-voltage functional circuits each of which has the same function, and at least a part of which is formed of high-voltage transistors, wherein
at least a part of the semiconductor circuits in the circuit element region is formed of low-voltage transistors,
the plurality of high-voltage functional circuits are provided adjacently to each other in the circuit element region, and
the inner isolation layers are formed, in the circuit element region, on the extended lines of the respective positions in which the plurality of high-voltage functional circuits are separated.

6. The semiconductor device according to claim 2,
wherein a plurality of aforementioned elongated circuit element regions are lined up in a direction perpendicular to the longitudinal direction thereof,
the semiconductor layer in the plurality of circuit element regions thus lined up is formed into n-type semiconductor layers and p-typesemiconductorlayers,whichare alternately arranged.

7. The semiconductor device according to claim 1, further comprising a plurality of gate electrodes formed in each of the plurality of semiconductor circuits, the plurality of gate electrodes formed in the same pattern from one semiconductor circuit to another.

8. The semiconductor device according to claim 1, wherein the element isolation layer and the inner isolation layer are formed of an insulating film of the semiconductor layer.

9. The semiconductor device according to claim 1, wherein the inner isolation layer is formed of a layer film containing at least one of NSG, SOG and polysilicon.

10. The semiconductor device according to claim 1, wherein at least a part of a driver circuit for image data is formed of the semiconductor circuits in the circuit element region.

11. The semiconductor device according to claim 10, wherein at least of a part of the driver circuit for the image data to be outputted to be displayed on a display device is formed of the semiconductor circuits in the circuit element region.
